Europäisches Patentamt

European Patent Office

Office européen des brevets

(19)

(11) Publication number : **0 404 565 B1**

# (12) EUROPEAN PATENT SPECIFICATION

(45) Date of publication of patent specification :
**18.05.94 Bulletin 94/20**

(51) Int. Cl.[5] : **H01L 33/00, H01L 31/0216, H01L 23/29**

(21) Application number : **90306788.2**

(22) Date of filing : **21.06.90**

(54) Compound semiconductor device and method of surface treatment of such a device.

(30) Priority : **21.06.89 JP 159330/89**

(43) Date of publication of application :
**27.12.90 Bulletin 90/52**

(45) Publication of the grant of the patent :
**18.05.94 Bulletin 94/20**

(84) Designated Contracting States :
**DE GB**

(56) References cited :
**DE-A- 3 310 373**
**JAPANESE JOURNAL OF APPLIED PHYSICS
vol. 27, no. 12, part 2, December 1988, pages
L2404-2407, Tokyo, JP; D.H. LEE et al.:
"Picosecond Responsive of A Planar
GaAs/A10.3GaO.7As Schottky Barrier Photo-
diode"
NewYork, US; R.M. GEFKEN et al.:
"Low-temperature plasma nitride field shield
for integrated circuits"**

(73) Proprietor : **MITSUBISHI KASEI
CORPORATION
5-2, Marunouchi 2-chome Chiyoda-ku
Tokyo 100 (JP)**

(72) Inventor : **Noguchi, Masahiro, c/o Mitsubishi
Monsanto Chem.Co
Tsukuba Kojo, 1000 Higashi Mamiana-cho
Ushiku-shi, Ibaraki 300-12 (JP)**
Inventor : **Ibuka, Toshihiko, c/o Mitsubishi
Monsanto Chem.Co
Tsukuba Kojo, 1000 Higashi Mamiana-cho
Ushiku-shi, Ibaraki 300-12 (JP)**

(74) Representative : **Diamond, Bryan Clive et al
Gee & Co. Chancery House Chancery Lane
London WC2A 1QU (GB)**

EP 0 404 565 B1

## Description

The present invention relates to a semiconductor device of compounds of elements of groups III - V of the periodic table, and a method for surface treatment of such semiconductors.

As a light-emitting diode (LED) for high luminance light emission consisting of an AlGaAs semiconductor, an LED of single hetero-junction structure or double hetero-junction structure has been conventionally used which has higher carrier injection efficiency, higher output and higher response speed than an LED of homo-junction structure.

These hetero-junction structure LEDs are characterized in that $Al_xGa_{1-x}As$ having a high AlAs mixed crystal ratio is used on the light-emitting side. For example, in the epitaxial growth of the substrate for a red-light-emitting high luminance LED, a Zn-doped $Al_{0.75}Ga_{0.25}As$ layer is formed 200 μm thick (p-type) on a p-type GaAs substrate [(100) surface] as a p-clad layer by a liquid growth method. Then, a Zn-doped $Al_{0.35}Ga_{0.65}As$ layer is formed 2-3 μm thick (p-type) as a p-active layer. Further, a Te-doped $Al_{0.75}Ga_{0.25}As$ layer is formed about 50 μm thick as an n-clad layer. Using a GaAs substrate selective etchant, an the light-absorption GaAs substrate is removed to obtain a high luminance LED chip. The mixed crystal ratio of the chip surface is as high as 0.75. An $Al_xGa_{1-x}As$ layer with such high AlAs mixed crystal ratio is however very easily oxidized. This results in easy deterioration of light-emitting characteristics and a shorter service life of the element. The same applies to the resin-sealed element.

To overcome this problem, the forming of an $SiN_x$ film has been proposed.

Also, it has been proposed to provide surface roughness in order to increase the external quantum efficiency by preventing total reflection on the surface.

In the past, however, it has been customary only either to provide the surface roughness (see e.g. DE-A-3310373) or to form an $SiN_x$ film (see e.g. D.H. Lee et al., Jap. J. of Appl. Phys. 27(12), part 2, pages L2404-L2407 (1988)). When only surface roughness is provided, there arise the problems of moisture resistance and shorter service life of the element due to surface oxidation. When only an $SiN_x$ film is furnished as the protective film, the bond strength is weak and the film is easily detachable.

By means of the present invention it is proposed to solve or at least reduce the above problems.

It is an object of the present invention to increase external quantum efficiency by preventing total reflection of the compound semiconductor device.

Another object of the invention is to prevent the detachment of a protective film by increasing the bond strength of the film to the compound semi-conductor device.

It is still another object of this invention to increase the moisture resistance of the compound semiconductor device, and to extend the service life of the element by preventing oxidation.

According to this invention we provide a compound semiconductor device comprising a compound of an element of group III - V of the periodic table, wherein roughness is formed on the surface of said compound semiconductor and a $SiN_x$ film is formed on said rough surface.

Further, this invention provides a surface treatment method for said semiconductor, in which roughness is formed on the surface by a physical or chemical method and a $SiN_x$ film is formed on the rough surface by a reduced pressure CVD method, plasma CVD method or sputtering method.

Preferably, the semiconductor has a mixed crystal ratio of 0 < AlAs < 1.

The thickness of the $SiN_x$ film is preferably 20 nm - 500 nm.

It is also preferable that the thickness of the $SiN_x$ film is an odd multiple of $\lambda/4n$, where $\lambda$ is the wavelength of the emitted light, and n is the refractive index of the film.

It is also preferable to use a plasma CVD method to form the $SiN_x$ film in this invention.

In the accompanying drawings:

Fig. 1 is a cross-section to show an example of the structure of an LED for high-luminance light-emission of this invention;

Fig. 2 is a graph to show the relationship between hydrogen content and silicon/nitrogen ratio of the protective film;

Fig. 3 is a graph of the relationship between hydrogen content and etching speed;

Fig. 4 shows the relationship between refractive index and silicon/nitrogen ratio;

Fig. 5 is a luminance histogram of an LED according to this invention;

Fig. 6 is a luminance histogram of a conventional type LED;

Fig. 7 and Fig. 8 are luminance histograms of an LED when its refractive index is changed;

Fig. 9 is an explanatory diagram to calculate reflectance;

Fig. 10 is a graph to show the relationship between film thickness and reflectance in an LED; and

Fig. 11 is a graph to show the relationship between film thickness of silicon oxide and reflectance.

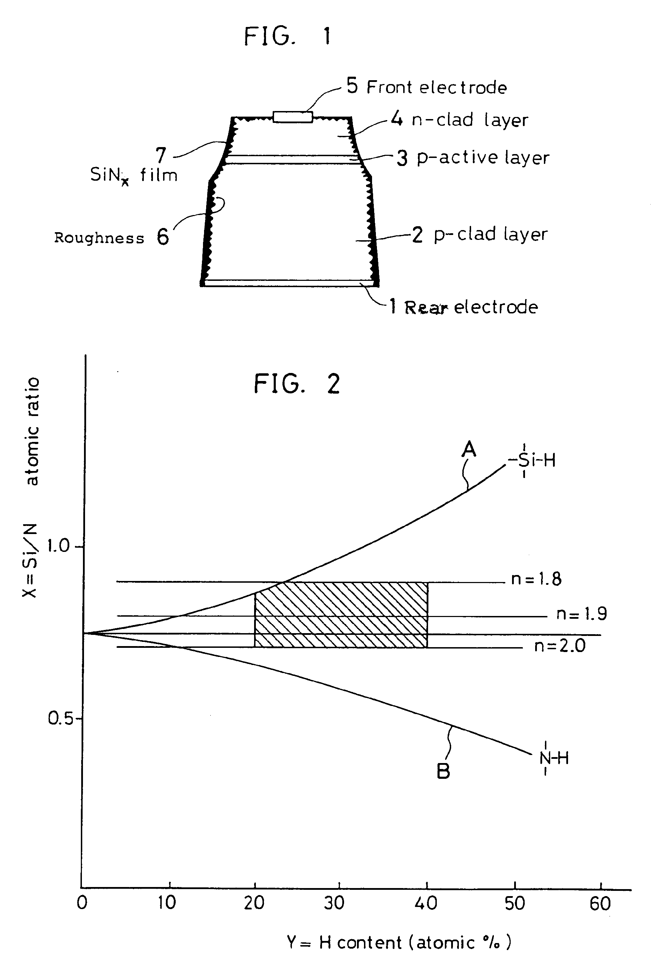

Fig. 1 shows an example of the structure of an LED for hetero-junction high luminance light emission according to this invention, wherein 1 refers to a rear electrode, 2 a p-clad layer, 3 a p-active layer, 4 an n-clad layer, 5 a front electrode, 6 surface roughness, and 7 an $SiN_x$ film.

The light-emitting diode consisting of an AlGaAs semiconductor shown in Fig. 1 comprises a p-active layer 3 sandwiched by clad layers 2 and 4, and the electrodes 1 and 5 are arranged on the front and rear surfaces of layer 3. This is performed by turning the interface with the semiconductor into an alloy by heat treatment after vacuum-depositing the electrodes. Next, the roughness 6 is formed on the entire surface of the LED, except the electrodes, by a physical method such as sandblasting or fine particle blowing, or by a chemical method such as etching. After forming the roughness, the $SiN_x$ film is formed as a protective film on the surface, for example, by the plasma CVD method.

In the $SiN_x$ film, the hydrogen content (atomic ratio) and silicon/nitrogen ratio (atomic ratio) are suitably as shown in the shaded portion of Fig. 2. The curve A of Fig. 2 represents the case where all the hydrogen atoms in the $SiN_x$ are bonded to silicon, and the curve B shows the case where all the hydrogen atoms are bonded to nitrogen. Normally, the value for $SiN_x$ is between these curves A and B. Because of the characteristics as a protective film, it is preferable to select the hydrogen content in such manner as to have the atomic ratio of about 20 - 40% and a refractive index of 1.8 - 2.0 and to provide the protective film with the composition given in the shaded portion of the figure, although the present invention is not thus limited.

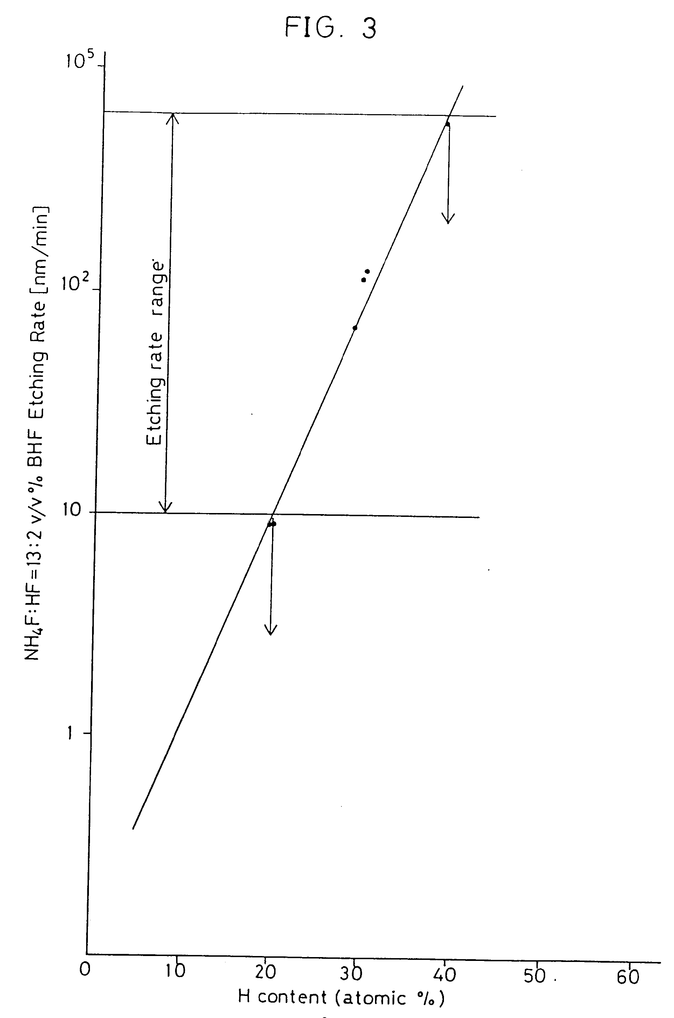

As shown in Fig. 3, hydrogen content in the $SiN_x$ is determined by the etching speed when etching is performed at the temperature of 25°C using an etching solution with a ratio of ammonium fluoride ($NH_4F$) to hydrofluoric acid of 13:2. Thus, the protective film has a perfect function if it is within the etching speed range of 10 - 600 nm/min. when film thickness is measured by an ellipsometer.

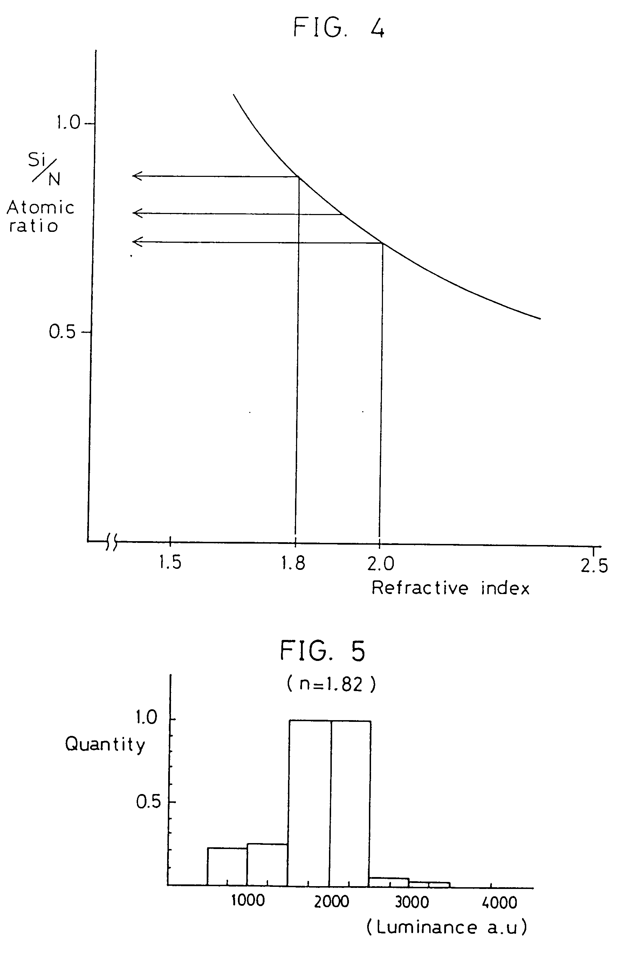

The relation between the refractive index of the protective film and the nitrogen/silicon ratio is as given in Fig. 4. By selecting the atomic ratio of silicon to nitrogen, it is possible to have the refractive index at 1.8 - 2.0.

If the film thickness is too thin, it cannot provide a perfect function as a protective film, whereas, if it is too thick, much time is required for film manufacture and there is also the possibility of detachment due to the stress of the film itself. A thickness of about 20 - 500 nm is adequate.

As the method to form the $SiN_x$ film, the plasma CVD method is the most preferable. Other useable methods include the reduced pressure CVD method and the sputtering method. For example, there is a thermal decomposition CVD method, by which $Si_3N_4$ is deposited on a substrate through a thermal decomposition reaction by introducing silane ($SiH_4$) and ammonia ($NH_3$) into the chamber. By this method, it is possible to obtain a film which is closer to a stoichiometric film (with Si/N ratio of 3:4) and has a lower hydrogen content. It is advantageous in that the etching rate can be decreased and a hard film is produced. In this case, a temperature of 600°C or more is required for the film manufacture.

In the reactive sputtering method, Si is processed by sputtering through discharge in an atmosphere (pressure: 1.3 to 133 Pa (1 x $10^{-2}$ Torr to 1 Torr) which is produced by mixing a small quantity of $N_2$ with argon with Si as the target, and $SiN_x$ is then deposited on the substrate. This method can be used for a compound semiconductor because there is no need to heat the substrate, while special care should be taken for stoichiometric control and stress control in the film.

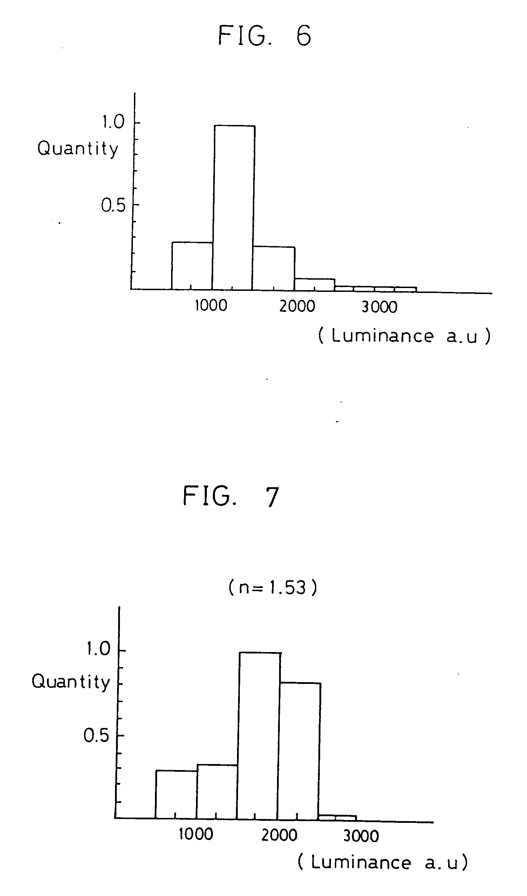

In a light-emitting diode, in which the atomic ratio of silicon to nitrogen was set to give a refractive index of 1.82 and a protective film with thickness of 270 nm (intraplanar homogeneity ± 5%) was formed, a luminance histogram was obtained to light of luminescent wavelength of 660 nm, and the results given in Fig. 5 were obtained. When measurement was made in the comparative cases where only roughness was provided or only an $SiN_x$ film was formed, the results were as shown in Fig. 6. In the figures, luminance is plotted on the abscissa (in any unit) and the quantity on the ordinate (standardized at the maximum for comparison purpose).

Average luminance of 1929 was obtained in the product according to the present invention, while it was 1373 in the conventional type of product, and luminance can evidently be improved by this invention.

Next, tests of durability have been performed for three cases: an LED provided with an $SiN_x$ film only, an LED furnished with roughness on its surface, and an LED according to the present invention. The results are summarized in Table 1.

|  | SiN$_x$ film only | Surface irreg- ularities only | Present invention |
|---|---|---|---|
| Test A | 81.8% | 82.8% | 96.7% |
| Test B | 78.1% | 76.7% | 93.6% |

In the table, Test A is a test where Step 1 and Step 2 are repeated 3 times each. (Step 1: Driven for 12 hours at 85°C and relative humidity (RH) of 95%; Step 2: Driven for 12 hours at -20°C and RH of 100%) . Test B is a test where, after performing Test A, Steps 3 and 4 are repeated 30 times each. (Step 3: Driven for 4 hours at 85°C and RH of 95%; Step 4: Driven for 4 hours at -20°C and RH of 100%.) In each step the driving current was 20 mA DC. The percentages in the table indicate the luminance residual ratio (ratio to the value at initial measurement).

As is evident from Table 1, the product according to this invention has a higher luminance residual ratio and its service life is considerably extended.

If the roughness is larger, light is scattered more, and there is no restriction on the degree of this roughness because it is enough if the bond strength of the SiN$_x$ film can be maintained. Preferably, the bottom-to-bottom distance or peak-to-peak distance of the roughness is 0.1 μm or more.

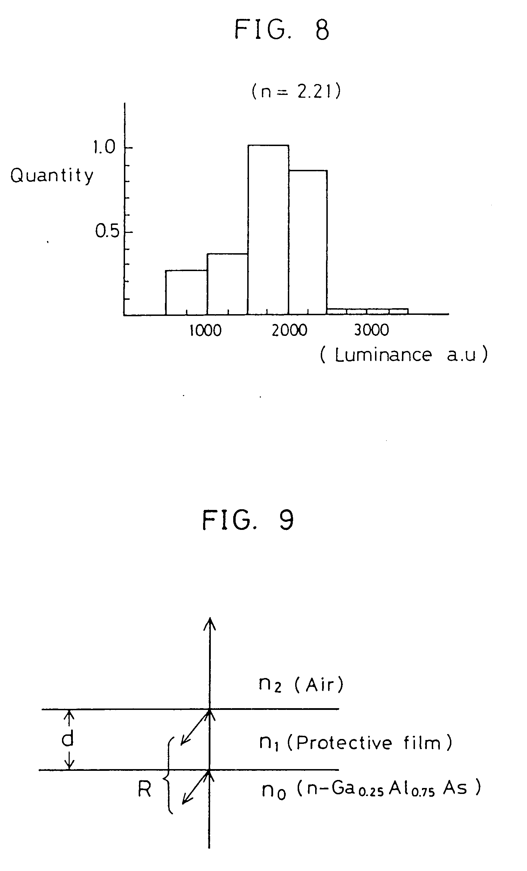

By a similar procedure as in the case of Fig. 5, the atomic ratio of Si/Ni was set to give the refractive index of 1.53 and 2.21 and a protective film with thickness of 270 nm (intraplanar homogeneity ± 5%) was formed. In this light-emitting diode, a luminance histogram was obtained to the light with a luminance wavelength of 660 nm, and the results were obtained as given in Figs. 7 and 8. The average luminance when the refractive index was 1.53 was 1754, and it was 1758 when the refractive index was 2.21.

Next, description will be given of the refractive index and the thickness of the protective film and reflectance, with reference to Fig. 9.

Suppose that the refractive index of an n-Al$_{0.75}$Ga$_{0.25}$As layer, protective film and the air is $n_0$, $n_1$ and $n_2$ respectively,

$$n_1 \cdot d = \frac{\lambda}{2\pi} \cdot \frac{\pi}{2} \times (\text{odd number})$$

$$= \frac{\lambda}{4} \times (\text{odd number})$$

When $n_0 = 3.3$ and $n_2 = 1.0$, and

$n_1 = \sqrt{n_0 n_2} = 1.82,$

$d \doteqdot 90$ nm x odd number

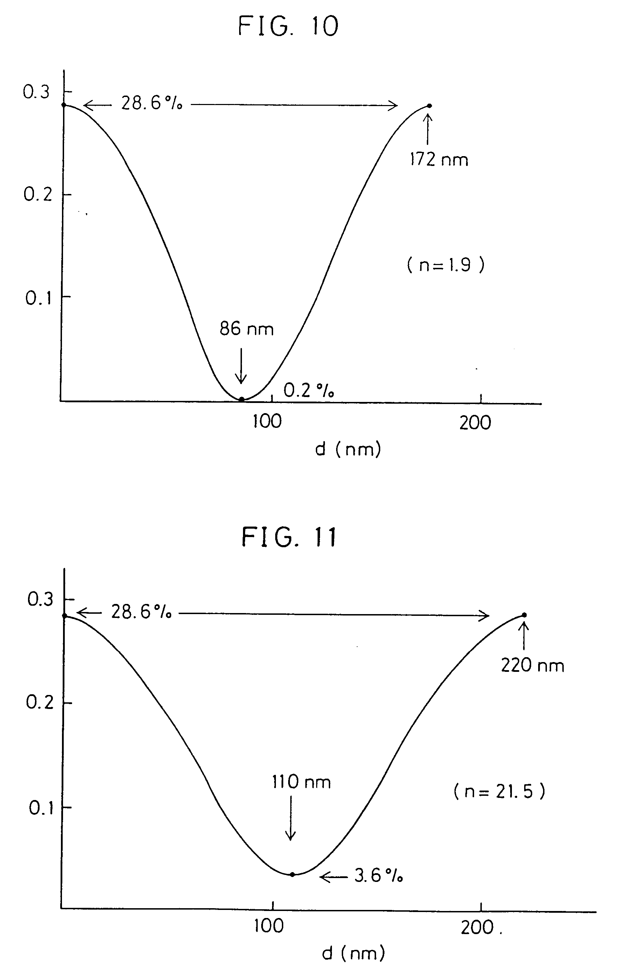

When the change of reflectance to the vertical direction in relation to film thickness d is obtained when the refractive index is 1.9, utilizing the above relationship, the result is as given in Fig. 10.

It is evident from the figure that, when the film thickness is an odd multiple of 86 nm, the reflectance is 0.2%, and high output characteristics can be achieved with the reflectance of this order. If the refractive index is within the range of 1.80 - 2.0, this condition can be satisfied.

Example 1

After electrodes were vacuum-deposited, alloy electrodes were prepared through heat treatment. After this the AlGaAs-LED wafer was immersed in a mixed solution containing aqueous hydrogen peroxide and ammonia (1:1) for one minute, it was washed with water for 30 seconds. It was further immersed in 3% HC1 aqueous solution to etch its surface. Then, it was washed with water for 15 minutes, neutralized with methyl alcohol and dried.

On the wafer roughened surface thus formed, an SiN$_x$ film was deposited by a plasma CVD method. As the condition to prepare the film, the gas flow rate was set to SiH$_4$ (20%/N$_2$), and a diluted solution was used of 15 sccm (cm³/min.; at 0°C; 1 atmospheric pressure), ammonia ($NH_3$) of 60 sccm, and nitrogen of 11 sccm. With full pressure of 6.6 Pa (5 x $10^{-2}$ Torr), substrate temperature at 280°C and RF power at 50 W, film was formed by the plasma CVD method with film preparation time of 28 min. As the result, a film with a thickness of about 270 nm and refractive index of 1.9 was obtained. By forming the surface roughness the external quantum efficiency was improved by about 40%. Because an $SiN_x$ film was formed, no decrease of luminance was noted in the durability test for 300 hours.

Comparative Example

When a silicon oxide film ($SiO_2$) was used as the protective film, the change of reflectance in relation to film thickness d is as shown in Fig. 11 when $n_1 = 1.5$.

As is evident from the figure, the reflectance reaches a minimum when the film thickness is 110 nm. It is still 3.6%, and it is apparent that high luminance output cannot be obtained.

As described above, it is possible by the present invention to increase the light takeoff efficiency by forming roughness on a III - V group compound semiconductor surface, and to increase the bond strength of the film itself by forming an $SiN_x$ film on the irregular surface. This makes it possible to prevent the detachment of the film, to extensively improve moisture resistance property and to extend service life because the deterioration of LED chips due to oxidation of the AlGaAs is reduced. Using an $SiN_x$ film as the protective film, the moisture resistance property is extensively increased compared with another passivation film such as a natural oxidation film or silicon oxide film. The service life is extended, and light emitting output can be increased by about 25%.

**Claims**

1. A compound semiconductor device comprising a compound of an element of group III - V of the periodic table, wherein roughness is formed on the surface of said compound semiconductor and a $SiN_x$ film is formed on said rough surface.

2. A compound semiconductor device according to Claim 1, wherein the III - V group compound semiconductor is an AlGaAs semiconductor having a mixed crystal ratio of 0 < AlAs < 1.

3. A compound semiconductor device according to Claim 1 or 2, wherein the $SiN_x$ film has a thickness of 20 to 500 nm.

4. A compound semiconductor device according to any preceding claim, wherein the thickness of said SiNx film is an odd multiple of $\lambda/4n$, wherein $\lambda$ is the wavelength of the emitted light, and n is the refractive index of the film.

5. A compound semiconductor device according to any preceding claim, wherein the $SiN_x$ film is formed by the plasma CVD method.

6. A surface treatment method of a compound semiconductor comprising a compound of an element of III - V of the periodic table, wherein roughness is formed on the surface of said semiconductor by a physical or chemical method, and a $SiN_x$ film is then formed on the rough surface by a reduced pressure CVD method, plasma CVD method or sputtering method.

7. A surface treatment method according to Claim 6, wherein the compound semiconductor is an AlGaAs semiconductor having a mixed crystal ratio of 0 < AlAs< 1.

**Patentansprüche**

1. Eine Verbindungshalbleitervorrichtung mit einer Verbindung von Elementen aus den Gruppen III-V des Periodensystems, wobei eine Rauhigkeit auf der Oberfläche des Verbindungshalbleiters und ein $SiN_x$-Film auf der rauhen Oberfläche ausgebildet sind.

2. Eine Verbindungshalbleitervorrichtung nach Anspruch 1, wobei der III-V Verbindungshalbleiter ein AlGaAs-Halbleiter mit einem Kristallmischungsverhältnis von 0 < AlAs < 1 ist.

3. Eine Verbindungshalbleitervorrichtung nach Anspruch 1 oder 2, wobei der SiN$_x$-Film eine Dicke von 20 bis 500 nm aufweist.

4. Eine Verbindungshalbleitervorrichtung nach einem der vorhergehenden Ansprüche, wobei die DicKe des SiN$_x$-Films ein ungeradzahliges Vielfaches von $\lambda/4n$ ist, wobei $\lambda$ die Wellenlänge des emittierten Lichts und n der Brechungsindex des Films ist.

5. Eine Verbindungshalbleitervorrichtung nach einem der vorhergehenden Ansprüche, wobei der SiN$_x$-Film durch ein Plasma-CVD-Verfahren gebildet ist.

6. Ein Verfahren zur Oberflächenbehandlung eines Verbindungshalbleiters mit einer Verbindung von Elementen der Gruppe III-V des Periodensystems, wobei eine Rauhigkeit auf der Oberfläche des Halbleiters durch ein physikalisches oder chemisches Verfahren gebildet wird, und ein SiN$_x$-Film anschließend auf der rauhen Oberfläche durch ein CVD-Verfahren bei reduziertem Druck, ein Plasma-CVD-Verfahren oder ein Sputterverfahren gebildet wird.

7. Ein Verfahren zur Oberflächenbehandlung gemäß Anspruch 6, wobei der Verbindungshalbleiter ein AlGaAs-Halbleiter mit einem Kristallmischungsverhältnis von 0 < AlAs < 1 ist.

## Revendications

1. Dispositif semi-conducteur composite, comprenant un composé d'un élément d'un groupe III-V du tableau périodique, dans lequel on rend rugueuse la surface de ce semi-conducteur composite et on forme un film de SiNx sur cette surface rugueuse.

2. Dispositif semi-conducteur composite selon la revendication 1, dans lequel le semi-conducteur composite d'un groupe III-V est un semi-conducteur Al Ga As ayant un rapport de cristaux mixtes de 0 < Al As < 1.

3. Dispositif semi-conducteur composite selon l'une des revendications 1 ou 2, dans lequel le film de SiNx a une épaisseur de 20 à 500 nm.

4. Dispositif semi-conducteur composite selon l'une des revendications précédentes, dans lequel l'épaisseur du film de SiNx est un multiple impair de $\lambda/4n$, $\lambda$ étant la longueur d'onde de la lumière émise et n étant l'indice de réfraction du film.

5. Dispositif semi-conducteur composite selon l'une des revendications précédentes, dans lequel le film de SiNx est formé par le procédé de déposition en phase vapeur par procédé chimique sous plasma.

6. Procédé de traitement de surface d'un semi-conducteur chimique comprenant un composé d'un élément d'un groupe III-V du tableau périodique, dans lequel la surface du semiconducteur est rendue rugueuse par un procédé physique ou chimique et on forme ensuite un film de SiNx sur cette surface rugueuse par un procédé de déposition en phase vapeur par procédé chimique sous pression réduite, un procédé de déposition en phase vapeur par procédé chimique sous plasma, ou par un procédé de pulvérisation.

7. Procédé de traitement de surface selon la revendication 6, dans lequel le semi-conducteur composite est un semi-conducteur Al Ga As ayant un rapport de cristaux mixtes de 0 < Al As < 1.

# FIG. 1

5 Front electrode
4 n-clad layer
7
SiN$_x$ film
3 p-active layer
Roughness 6
2 p-clad layer
1 Rear electrode

# FIG. 2

atomic ratio

$X = Si/N$

A  —Si—H
1.0
n = 1.8
n = 1.9
n = 2.0
0.5
B  —N—H

0    10    20    30    40    50    60

Y = H content (atomic %)

# FIG. 3

# FIG. 4

# FIG. 5

( n=1.82 )

FIG. 6

FIG. 7

# FIG. 8

(n = 2.21)

Quantity

1.0

0.5

1000    2000    3000

( Luminance  a.u )

# FIG. 9

$n_2$ (Air)

d

$n_1$ (Protective film)

R

$n_0$ (n-Ga$_{0.25}$Al$_{0.75}$As)

# FIG. 10

# FIG. 11